Europäisches Patentamt

European Patent Office

Office européen des brevets

(11) Veröffentlichungsnummer: **0 282 836 B1**

(12) **EUROPÄISCHE PATENTSCHRIFT**

(45) Veröffentlichungstag der Patentschrift: **14.10.92**

(21) Anmeldenummer: **88103333.6**

(22) Anmeldetag: **04.03.88**

(51) Int. Cl.⁵: **C23C 14/34**, H01J 37/34

(54) Verfahren und Vorrichtung zum Aufstäuben hochohmiger Schichten durch Katodenzerstäubung.

(30) Priorität: **20.03.87 DE 3709175**

(43) Veröffentlichungstag der Anmeldung:
**21.09.88 Patentblatt 88/38**

(45) Bekanntmachung des Hinweises auf die
Patenterteilung:
**14.10.92 Patentblatt 92/42**

(84) Benannte Vertragsstaaten:
**AT BE CH DE FR GB IT LI NL**

(56) Entgegenhaltungen:
**EP-A- 0 047 395**
**EP-A- 0 205 028**
**US-A- 4 572 842**

(73) Patentinhaber: **LEYBOLD AKTIENGESELL-
SCHAFT**
**Wilhelm-Rohn-Strasse 25, Postfach 1555**
**W-6450 Hanau am Main 1(DE)**

(72) Erfinder: **Wirz, Peter, Dr.**
**Klosterstrasse 5**
**W-6296 Waldernbach(DE)**

(74) Vertreter: **Zapfe, Hans, Dipl.-Ing.**
**Am Eichwald 7**
**W-6056 Heusenstamm 2 Rembrücken(DE)**

## Beschreibung

Die Erfindung betrifft ein Verfahren nach dem Oberbegriff des Patentanspruchs 1.

Während das Aufstäuben niederohmiger, metallischer Schichten verfahrenstechnisch nur geringe Probleme verursacht, ist die Herstellung hochohmiger Schichten verhältnismäßig problematisch, weil sich mit fortschreitender Prozeßdauer metallische Vorrichtungsteile, die bestimmte Potentialdifferenzen zueinander aufweisen müssen, zunehmend mit dem hochohmigen Schichtmaterial überziehen, wobei diese Beschichtung sich auch noch flächenmäßig ausbreitet. Dadurch entsteht ein Driften der Prozeßparameter, das den Beschichtungsprozeß instabil werden läßt, so daß die durch den Prozeß hergestellten Produkte mit zunehmender Verfahrensdauer unterschiedliche Eigenschaften aufweisen. Unter "hochohmigen Schichten" versteht man solche mit spezifischen Widerständen oberhalb $5 \times 10^{-4}$ Ohm/cm, jedoch ist dieser Grenzwert nicht kritisch und von Fall zu Fall unterschiedlich zu werten. Derartige Schichten haben an Kondensationsflächen für die gestreuten Partikel bereits die Eigenschaften von Isolatorschichten.

Bei dem Reaktionsgas kann es sich beispielhaft um ein reines Reaktionsgas wie Sauerstoff oder Stickstoff handeln, oder um ein Gemisch mindestens eines dieser Gase mit einem für den Zerstäubungsprozeß benötigten Inertgas wie beispielsweise Argon.

Um dabei den Zerstäubungsprozeß mit Gleichspannung betreiben zu können, muß das Target elektrisch leitfähig sein; es besteht im allgemeinen aus einem Metall, das die eine Reaktionskomponente für die zu erzeugende Schicht bildet, während die andere Reaktionskomponente dem Reaktionsgas entstammt. Durch das Zusammenwirken von Metalldampfstrom und Reaktionsgas erfolgt auf dem Substrat die Abscheidung der gewünschten Verbindungen. Das Reaktionsgas wirkt jedoch auch auf die Targetoberfläche ein und erzeugt dort auf einem mehr oder weniger großen Bereich der Targetoberfläche einen Isolierbelag, durch den die Zerstäubungsrate verringert und die Stabilität des Prozesses beeinträchtigt wird. Von dem Isolierbelag weitgehend freigehalten wird dabei im allgemeinen nur der bei Magnetronkatoden typische Erosionsgraben, der innerhalb des aus magnetischen Feldlinien bestehenden Tunnels verläuft, durch den die Plasmaentladung eingeschlossen wird. Am Grunde des Erosionsgraben ist bei praktisch brauchbarer Verfahrensführung die Zerstäubungsrate so groß, daß sich kein störender Isolierbelag ausbilden kann. Hierbei ist jedoch noch auf eine Reihe weiterer Verfahrensparameter zu achten.

Um eine genügende Prozeßstabilität zu erhalten, wird im allgemeinen mit hoher Entkopplung zwischen Substrat und Target gearbeitet. Bei hoher Entkopplung ist aufgrund des Flächenverhältnisses von Substratfläche zu effektiver Targetfläche (Fläche des Erosionsgraben auf dem Target) die Wirkung des Reaktionsgases am Substrat relativ gegenüber der Wirkung auf dem Target erhöht. Eine hohe Entkopplung wird unter anderem durch einen großen Abstand zwischen Target und Substrat erreicht, der üblicherweise etwa 100 mm beträgt.

Eine weitere Maßnahme zur Entkopplung ist die Trennung der Einlaßstellen von Arbeitsgas (z.B. Argon) und Reaktionsgas, wobei das Arbeitsgas in Targetnähe und das Reaktionsgas (oder ein Gemisch aus Arbeits- und Reaktionsgas) in Substratnähe eingelassen wird. Eine relativ hohe Prozeßstabilität wird erreicht, wenn zusätzlich eine zwischen den Einlaßstellen der Gase liegende Blende eingeführt wird, die den substratnahen Bereich von den targetnahen Bereich weitgehend trennt. Diese Blende wirkt einmal als zusätzliche Getterfläche für das Reaktionsgas im targetnahen Bereich. Das Einbringen von Reaktionsgas in den targetnahen Bereich wird dadurch reduziert und gleichzeitig die Wirkung des Reaktionsgases auf dem Substrat erhöht. Insbesondere beim Aufstäuben von isolierenden Schichten muß beim Arbeiten mit einer Blende der Entladungsstrom durch eine zusätzliche Anode aufrechterhalten werden, die auf der dem Substrat zugekehrten Seite der Blende angeordnet ist (DE-OS 33 31 707).

Die bekannten Lösungen führen jedoch zu technischen Nachteilen. So sind beispielsweise die erzielbaren Niederschlagsraten aufgrund des großen Target-Substrat-Abstandes, insbesondere aber wegen des Auftreffens von etwa 60 % des zerstäubten Targetmaterials auf der Blende, erheblich reduziert. Weiterhin wird durch die Blende auch das Plasma im substratnahen Bereich in seiner Dichte merklich reduziert. Infolgedessen muß mit einem größeren Überschuß an Reaktionsgasen gearbeitet werden, was an sich der Forderung nach einer Erhöhung der Prozeßstabilität durch das Fernhalten des Reaktionsgases vom Target diametral entgegengesetzt ist. Da bestimmte Schichteigenschaften außerdem nur bei starker Plasmaeinwirkung erreicht werden können, ist die bekannte Lösung insbesondere auch für die ionenunterstützte Beschichtung ungeeignet. Weiterhin neigt die bekannte Vorrichtung zusätzlich zu Betriebsstörungen, da auf der Blende Schichten aufwachsen, die, insbesondere wenn es sich um Isolierschichten handelt, abblättern.

Der Erfindung liegt daher die Aufgabe zugrunde, ein Verfahren der eingangs beschriebenen Gattung anzugeben, mit dem Isolierschichten bzw. hochohmige Schichten mit hoher Rate bei großer Prozeßstabilität abgeschieden werden können.

Die Lösung der gestellten Aufgabe erfolgt erfindungsgemäß durch die im Kennzeichen des Anspruchs 1 angegebenen Maßnahmen.

Diese Maßnahmen führen im Gegensatz zum Stande der Technik zu einer extrem großen Kopplung zwischen Reaktionsgas und Target einerseits und Target und Substrat andererseits, was insbesondere durch die Anordnung des Gaseinlasses in Targetnähe und den kurzen Substratabstand erreicht wird. Entscheidend wirkt jedoch bei der Lösung der Aufgabe die Erzielung hoher Niederschlagsraten mit, die dadurch erreicht wird, daß praktisch ohne Blende gearbeitet wird. Die Öffnung in der Abschirmeinrichtung ist dabei so groß auszuführen, daß der größte Teil des Partikelstromes durch sie hindurch treten kann. Die Öffnung in der Abschirmeinrichtung wirkt praktisch nicht mehr als Blende, wenn sie etwa der Breite des Targets entspricht oder sogar größer ist.

Es ist daher besonders zweckmäßig, wenn man den Abstand "x" zwischen den Innenrändern der Abschirmeinrichtung zwischen dem 0,6-Fachen und dem 2,0-Fachen der Querabmessung "c" des Targets wählt.

Bei einem kreisscheibenförmigen Target ist die Querabmessung "c" der Durchmesser des Targets, und der Abstand "x" entspricht dem Innendurchmesser der Abschirmeinrichtung. Diese Abstimmung läßt sich ohne weiteres auch auf rechteckige Targets übertragen, bei denen die Innenränder der Abschirmeinrichtung alsdann parallel zueinander im Abstand "x" verlaufen.

Durch die genannte Dimensionierungsvorschrift wird erreicht, daß mindestens 60 % des Partikelstromes ungehindert in Richtung auf das Substrat strömen kann.

Es ist dabei besonders vorteilhaft, wenn die Abschirmeinrichtung, die bei einer bestimmten Verfahrensführung auch eine Anodenfunktion ausübt, in unmittelbarer Nähe der Substratebene angeordnet ist. Hierbei ist es besonders vorteilhaft, wenn der Abstand "d" zwischen der dem Target zugekehrten Oberfläche der Abschirmeinrichtung und dem Substrat maximal der Summe der Dicke der Abschirmeinrichtung und einem Spalt mit einer Weite von 5 mm entspricht. Dadurch kann das Plasma praktisch unbehindert und mit hoher Dichte auf das Substrat bzw. die dort im Aufbau befindliche Schicht einwirken.

Bei der erfindungsgemäßen Verfahrensweise kann der Entladungsstrom nicht zu der üblicherweise vorhandenen Dunkelraumabschirmung bzw. zum Plasmaschirm gelangen, sondern wird in Substratnähe abgeleitet. Auf diese Weise erhöht sich die Plasmadichte im substratnahen Bereich. Dies hat zur Folge, daß das Reaktionsgas effektiver genutzt wird, d.h. im Vergleich zur Verfahrensweise mit einer Entkopplung wird weitaus weniger Reaktionsgas für die Erzielung eines bestimmten Reaktionsgrades benötigt. Entgegen allen bisherigen Lehren kann durch diese Art der Gestaltung der Potentialverhältnisse im Bereich der Abschirmeinrichtung bzw. der Anode überraschenderweise eine Zunahme der Grundstabilität der Entladung erreicht werden.

Ein ganz entscheidender Vorteil bei der erfindungsgemäßen Verfahrensweise ist der Gewinn an einer Langzeitkonstanz der Beschichtungsparameter und damit der Schichteigenschaften. Beim reaktiven Abscheiden von Verbindungen bzw. hochohmigen Schichten ist es unvermeidlich, daß sich auf der Abschirmeinrichtung oder anderen in der Nähe der Reaktionszone befindlichen Vorrichtungsteilen isolierende Schichten abscheiden. Da es sich bei den genannten Teilen in der Regel um elektrisch leitfähige Metallteile handelt, verändert sich die Potentialverteilung im laufe der Beschichtung.

Dadurch verschiebt sich praktisch die wirksame Anode im laufe der Zeit von der Nähe der Katode bis in die Substratnähe. Je nach der Niederschlagsrate und der Schichtdicke können diese Verschiebungszeiten von wenigen Minuten bis zu über einer Stunde dauern. Die Folgen einer solchen Änderung der Potentialverhältnisse für die Schichteigenschaften sind untragbar.

Zwar wird auch bei dem erfindungsgemäßen Verfahren auf der Abschirmeinrichtung Beschichtungsmaterial kondensiert, jedoch wird durch die erfindungsgemäße Verfahrensführung erreicht, daß diese Einflüsse keine schädlichen Auswirkungen auf die Langzeitstabilität der Prozeßparameter haben. Es werden nämlich dadurch von Anfang an definierte und für den Beschichtungsvorgang optimale Potentialverhältnisse erreicht.

Es ist dabei besonders vorteilhaft, wenn man die Saugleistung einer den Unterdruck bestimmenden Vakuumpumpeinrichtung einerseits und die pro Zeiteinheit zugeführte Menge an Reaktionsgas andererseits so einstellt, daß aus der Reaktionszone zwischen Target und Substrat weniger als 1/3, vorzugsweise weniger als 1/5 des zugeführten Reaktionsgases unverbraucht abgezogen wird.

Auch diese Maßnahme steht im Widerspruch zu den Lehren des Standes der Technik, bei dem regelmäßig mehr als die Hälfte des zugeführten Reaktionsgases, in den meisten Fällen sogar ein Vielfaches des zugeführten Reaktionsgases unverbraucht durch die Vakuumpumpen abgezogen wird.

Man kann dabei auf besonders einfache Weise das Verhältnis von zugeführter zu unverbraucht abgesaugter Menge an Reaktionsgas durch die Wahl einer Spaltweite zwischen einem die Katode umgebenden Innengehäuse und dem Substrat festlegen. Dadurch läßt sich erreichen, daß die Differenz zwischen den Gesamtdrücken in dem genannten Innengehäuse und in der das Innengehäuse umgebenden Vakuumkammer klein gegen einen Faktor 2 ist.

Diese Maßnahmen stehen, wie bereits gesagt, im Gegensatz zu den Lehren des Standes der Technik, bei denen stets angegeben wird, daß die Prozeßstabilität durch Erhöhung der Saugleistung der Vakuumpumpen einerseits und durch eine Erhöhung des zugeführten Flusses an Reaktionsgas andererseits erhöht werden soll, was im Grund darauf hinausläuft, daß der Durchsatz an Reaktionsgas erhöht wird, mit dem Ergebnis, daß nur ein geringer Teil des Reaktionsgases in die gewünschten chemischen Verbindungen umgesetzt wird.

Eine Erhöhung der Saugleistung der Vakuumpumpeinrichtung führt jedoch zu einer anderen Schwierigkeit, nämlich zu einer Begrenzung der Kondensationsrate bei Schichten mit hohem Reaktionsgrad, bzw., bei gegebener Kondensationsrate zu einer Begrenzung des Reaktionsgrades. Es wird angenommen, daß die Ursache hierfür darin liegt, daß mit einer Erhöhung des Reaktionsgasdurchsatzes auch das für die Einstellung eines bestimmten Reaktionsgrades erforderliche Stoßzahlverhältnis ebenfalls höher sein muß.

Mit der Verringerung der unverbraucht abgezogenen Menge an Reaktionsgas geht notwendigerweise auch eine Verringerung der Saugleistung der Vakuumpumpeinrichtung einher, und es konnte beobachtet werden, daß dadurch neben einer hohen Prozeßstabilität auch ein höherer Reaktionsgrad als bisher erzielt werden konnte.

Es wird dadurch erreicht, daß das Reaktionsgas von der Einlaßstelle in Targetnähe nahezu vollständig in den Bereich des dichten Plasmas vor der Targetoberfläche strömen muß und von dort zum Substrat diffundiert, wo es in der chemischen Reaktion zum größten Teil verbraucht wird, bevor ein geringer Anteil durch die dort installierten Spalte abgesaugt wird. Die Dichte angeregter Reaktionsgasteilchen vor der Substratoberfläche wird auf diese Weise deutlich erhöht. Das hat wiederum zur Folge, daß das notwendige Stoßzahlverhältnis zur Einstellung des geforderten Reaktionsgrades geringer ist. Infolgedessen kann bei gleichem oder sogar geringerem Reaktionsgasfluß eine größere Metallmenge pro Zeiteinheit bei höherem Reaktionsgrad umgesetzt werden. Das erklärt auch, daß die Entladung bei Anwendung des erfindungsgemäßen Verfahrens stabil betrieben werden kann, obwohl ansich zu erwarten gewesen wäre, daß das Einlassen des Reaktionsgases in Targetnähe, insbesondere aber die enge Koppelung zwischen Target und Substrat an sich die Grundstabilität der Entladung verringern würde.

Die Erfindung betrifft auch eine Vorrichtung zur Durchführung des erfindungsgemäßen Verfahrens nach dem Oberbegriff des Anspruchs 10.

Die Lösung der gleichen Aufgabe erfolgt erfindungsgemäß durch die Merkmale im Kennzeichen des Anspruchs 10.

Weitere vorteilhafte Ausgestaltungen des Erfindungsgegenstandes ergeben sich aus den übrigen Unteransprüchen.

Ausführungsbeispiele des Erfindungsgegenstandes werden nachfolgend anhand der Figuren 1 bis 3 näher erläutert.

Es zeigen:

Figur 1     zwei Varianten einer Vorrichtung zur Erzeugung von Schichten mit einer immerhin noch merklichen Leitfähigkeit,

Figur 2     zwei Varianten einer Vorrichtung zur Erzeugung von Schichten, die als ausgesprochene Isolierschichten angesprochen werden können,

Figur 3     eine praktische Ausführungsform einer Vorrichtung, die im wesentlichen der Variante gemäß Figur 1, rechter Teil, entspricht.

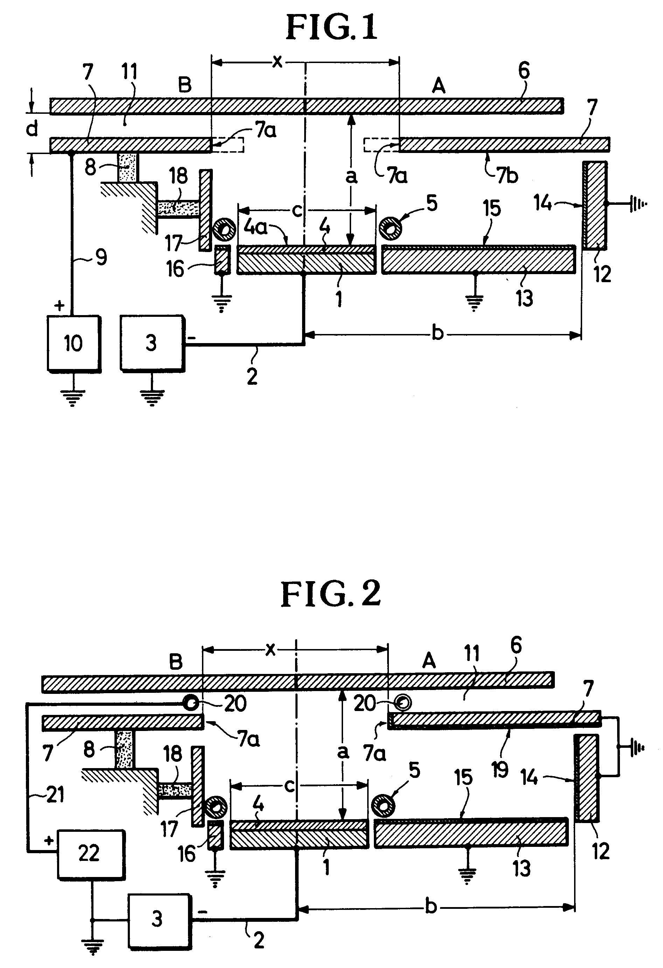

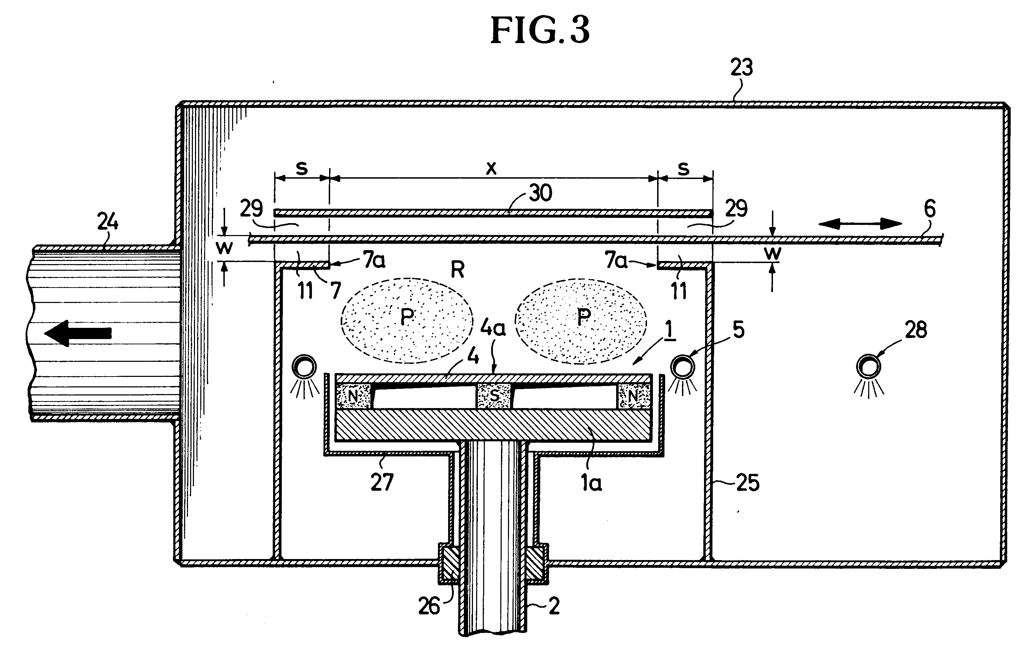

In Figur 1 ist eine Magnetronkatode 1 dargestellt, die - für sich genommen - zum Stande der Technik gehört. Einzelheiten der prinzipiellen Bauweise einer solchen Magnetronkatode sind außerdem Figur 3 zu entnehmen. Die Magnetronkatode 1 ist über eine Leitung 2 mit einer Gleichspannungsquelle 3 verbunden, die eine negative Gleichspannung zwischen etwa 400 und 1000 Volt abzugeben im Stande ist. Die Magnetronkatode 1 ist mit einem etwa kongruenten Target 4 aus einem elektrisch leitfähigen Material belegt, das die eine Komponente des zu bildenden Schichtmaterials liefert. Das Target besitzt eine Oberfläche 4a, die die sogenannte Zerstäubungsfläche ist.

Die Magnetronkatode bzw. das Target 4 ist im Randbereich von einer Verteileinrichtung 5 für das Reaktionsgas umgeben, wobei der Abstand kleinstmöglich gewählt ist, ohne daß jedoch die Verteileinrichtung 5 und die Targetoberfläche 4a in der Draufsicht gesehen einander überschneiden. Die nicht näher bezeichneten Austrittsöffnungen der Verteileinrichtung 5 sind nach unten gerichtet. Das Target 5 hat die Querabmessung "c". Bei einem kreisrunden Target 4 ist auch die Verteileinrichtung 5 als Ringleitung dargestellt, was hier der Übersichtlichkeit halber in der Zeichnung nicht festgehalten ist.

In planparalleler Ausrichtung zur Targetoberfläche 4a wird an der Magnetronkatode 1 ein Substrat 6 vorbeibewegt, das mit dem Reaktionsprodukt aus dem Targetmaterial und dem Reaktionsgas beschichtet werden soll. Der Abstand von der Targetoberfläche 4a zum Substrat 6 hat das Maß "a". Dieser Abstand liegt zwischen 40 und 60 mm, während die Querabmessung "c" des Targets nicht weiter kritisch ist und die üblichen Abmessungen aufweist. Innerhalb dieses Abstandes "a" liegt - in größerer Nähe zum Substrat 6 - eine Abschirmeinrichtung 7, deren Innenränder 7a einen Abstand "x" voneinander aufweisen, der zwischen dem 0,6-Fachen und dem 2,0-Fachen der Querabmessung "c" des Targets 4 liegt. Die Variabilität dieses Abstandes "x" wird durch die gestrichelten Verlängerungen der Abschirmeinrichtung 7 symbolisiert.

Die Abschirmeinrichtung 7 ist isoliert angeordnet, was durch einen auf der linken Seite dargestellten Stützisolator 8 angedeutet ist. Sie ist weiterhin über eine Leitung 9 mit einer Gleichspannungsquelle 10 verbunden, die im Stande ist, eine Gleichspannung zwischen 0 und +200 Volt abzugeben. Die dem Target 4 zugekehrte Oberfläche 7b der Abschirmeinrichtung hat von dem Substrat 6 einen Abstand "d", der kleiner ist als die Hälfte des Abstandes "a". Beim Ausführungsbeispiel ist der Abstand "d" maximal der Summe der Dicke der Abschirmeinrichtung 7 und der Weite eines Spaltes 11 von etwa 5 mm.

Im rechten Teil von Figur 1 (Teil A) ist eine Anordnung dargestellt, bei der die Magnetronkatode 1 einen relativ großen Abstand von einer seitlich daneben liegenden Wand 12 der Vakuumkammer hat. Der Abstand wird durch eine weitere Wand 13 der Vakuumkammer überbrückt, die insgesamt auf Massepotential liegt. Im vorliegenden Fall hat der Abstand der Kammerwand 12 von der Mittenachse der Katode 1 das Maß "b", und dieses beträgt b = 2 c. Bei dieser Anordnung belegen sich die Kammerwände 12 und 13 mit Schichten 14 und 15 aus mindestens teilweise isolierendem Material, wodurch die Kammerwände gegenüber dem Aus-gangszustand allmählich ihre Anodenfunktion ver-lieren.

Im linken Teil von Figur 1(Teil B) ist die Magentronkatode unter beengten Raumverhältnissen dargestellt, d.h. die Wand 16 der auf Massepotential liegenden Vakuumkammer ist sehr viel kürzer. Um hierbei eine Veränderung der Potentialverhältnisse mit fortschreitender Beschichtungsdauer zu verhindern, ist die unmittelbar angrenzende seitliche Wand 17 der Vakuumkammer isoliert aufgehängt, was durch einen Stützisolator 18 angedeutet ist. Dadurch kann die Wand 17 sich selbst auf ein frei gewähltes Zwischenpotential einstellen.

Die beiden Varianten nach Figur 1 eignen sich insbesondere für die Abscheidung von Schichten mit einer gewissen Restleitfähigkeit, wie z.B. von $SiO_2$. Dabei sind die als Anode wirkenden Teile entweder an Masse oder an positives Potential gegen Masse angeschlossen und im direkten Partikelstrom vor dem Substrat angeordnet. Auf den als Anode wirkenden Teilen kondensieren in diesem Falle Schichten, die für die Aufnahme des Entladungsstroms noch ausreichend leitfähig sind. Auf den anderen Flächen können sich ohne weiteres isolierende Schichten abscheiden. Wird mit Nullpotential an der als Anode wirkenden Abschirmeinrichtung 7 gearbeitet, so kann sie mit der Wand 12 kurzgeschlossen werden (Figur 2 , Teil A). In der Regel ist jedoch die als Anode wirkende Abschirmeinrichtung 7 von den umgebenden, als Plasmaschirm wirkenden Wänden getrennt angeordnet, z.B. dann, wenn diese Wände wie die Wand 17 "floaten" können, weil sie isoliert aufgehängt sind (Figur 1, Teil B).

Die beiden Varianten A und B nach Figur 2 stimmen in Abmessungen und Anordnung im wesentlichen mit den entsprechenden Varianten A und B nach Figur 1 überein, so daß gleiche Bezugszeichen verwendet wurden. Wie bereits weiter oben ausgeführt wurde, sind die Varianten nach Figur 2 jedoch für die Herstellung isolierender Schichten vorgesehen. In diesem Falle kondensiert auch auf der Abschirmeinrichtung 7 eine isolierende Schicht 19, so daß diese - zumindest nach einiger Zeit - nicht mehr die Funktion einer Anode ausüben kann. Um hier eine Anodenfunktion sicher-zu-stellen, ist in Zerstäubungsrichtung gesehen hinter der Abschirmeinrichtung 7 eine besondere Anode 20 angeordnet, die als wasserdurchströmtes Rohr ausgebildet ist. Die Anode 20 ist über eine Leitung 21 mit einer Gleichspannungsquelle 22 verbunden, durch die die Anode mit einer positiven Spannung zwischen etwa 40 und 120 Volt beaufschlagbar ist. Die Anode 20 ist dabei im Spalt 11 gegenüber den Kanten 7a soweit zurückgesetzt, daß sie nur noch in sehr geringem Umfange von isolierenden Partikeln getroffen werden kann. Die Abschirmeinrichtung 7 ist entweder zusammen mit den Wänden 12 und 13 an Massepotential gelegt (Figur 2, Teil A) oder auf einem selbsttätig frei einstellbaren Potential durch einen Stützisolator 8 gehalten (Figur 2, Teil B). In jedem Falle hat die Abschirmeinrichtung 7 auch in Bezug auf die besondere Anode 20 eine Abschirmfunktion.

Wie aus Figur 2 zu ersehen ist, sind die Anode 20 und die Abschirmeinrichtung 7 beide in großer Substratnähe angeordnet, und zwar in der Weise, daß der auf das Substrat 6 gelangende Anteil des Beschichtungsmaterials durch die Abschirmeinrichtung 7 praktisch nicht geändert wird. Die Potential-verhältnisse im gesamten Plasmaraum, insbeson-dere in der Substratnähe, bleiben zeitlich und räumlich stabil, wenn auf den genannten Oberflächen eine isolierende Schicht entsteht oder bereits vorhanden ist. Dabei müssen die genannten Teile jedoch elektrisch leitend sein, da sie sonst ihre Aufgaben im Bereich der Katode, störende Nebenentladungen zu unterdrücken, nicht erfüllen könnten.

Man kann zur Erzielung von Betriebsbedingungen, die von Anfang an stabil sind, auch so verfahren, daß man die genannten Oberflächen in einer Art Formierungsphase vor der eigentlichen Beschichtung der Substrate gezielt mit isolierenden Schichten versieht.

Bei dem Ausführungsbeispiel nach Figur 3 ist schematisch auch eine Vakuumkammer 23 dargestellt, die in den Figuren 1 und 2 fortgelassen wurde. Diese Vakuumkammer ist über einen Saugstutzen 24 mit einem Satz nicht gezeigter Vakuumpumpen verbunden. Innerhalb der Vakuumkammer 23 ist ein Innengehäuse 25 angeordnet, das die Magnetronkatode 1 und die Verteileinrichtung 5 möglichst eng einschließt. Die Katode 1 mit ihrem Target 4 ist hier jedoch etwas mehr im Detail dargestellt, und zwar sind hier die Magnetpole N und S dargestellt, die über der Targetoberfläche 4a einen in sich geschlossenen Feldlinientunnel erzeugen, in dem das Plasma P eingeschlossen ist. Das Plasma folgt dabei dem Verlauf der Polflächen; bei einer kreisförmigen Magentronkatode hat es in etwa die Form eines Torus. Zur Magnetronkatode 1 gehört noch ein Katodengrundkörper 1a. Die Leitung 2 ist hier als Tragrohr ausgeführt und mittels eines Durchführungsisolators 26 durch die Wand der Vakuumkammer 23 hindurchgeführt. Die Seiteneinflächen, die Rückseite und die Leitung 2 sind von einer gleichfalls auf Massepotential liegenden Dunkelraumabschirmung 27 umgeben.

Die Abschirmeinrichtung 7 ist hierbei Teil des Innengehäuses 25 und liegt mit diesem auf Massepotential. Zwischen den Innenrändern 7a wird in analoger Weise wie in den Figuren 1 und 2 eine Austrittsöffnung für das Beschichtungsmaterial gebildet, die die Abmessung "x" aufweist . Zwischen der Abschirmeinrichtung 7 und dem Substrat 6 wird jedoch auf dem Umfang des Innengehäuses 25 ein umlaufender Spalt 11 mit einer definierten Weite w und einer definierten Länge s gebildet. Hierdurch entsteht ein gewisser Drosseleffekt, der jedoch einen Gasaustausch durch Strömung und Diffusion ermöglicht. Durch die Verteileinrichtung 5 kann entweder reines Reaktionsgas oder Reaktionsgas im Gemisch mit einem Arbeitsgas (Argon) zugeführt werden. Außerhalb des Innengehäuses 25, aber innerhalb der Vakuumkammer 23 ist eine weitere Verteileinrichtung 28 angeordnet, durch die beispielhaft reines Arbeitsgas (Argon) zugeführt wird.

Durch das Innengehäuse 25 wird (in Analogie zur Wand 17 in den Figuren 1 und 2) zwischen Target 4 und Substrat 6 eine Reaktionszone R abgegrenzt, und durch den Spalt 11 wird ein solcher Gleichgewichtszustand der Gasbewegungen erreicht, daß aus der Reaktionszone R weniger als 1/3, vorzugsweise weniger als 1/5 des unverbrauchten Reaktionsgases durch den Saugstutzen 24 abziehbar ist . Der Spalt 29 auf der Rückseite des Substrats 6 ist weniger kritisch. Er wird durch eine Platte 30 begrenzt, die jedoch für den Plasmaprozeß Bedeutung erlangt, wenn das Substrat 6 beispielsweise aus einer Folge von einzelnen plattenförmigen Substraten besteht, die mit Abstand durch die Reaktionszone R geführt werden.

Durch die vorstehend beschriebenen Maßnahmen wird erreicht, daß das Reaktionsgas von der Verteileinrichtung 5 in der Nähe des Targets nahezu vollständig in den Bereich des dichten Plasmas vor der Targetoberfläche strömt und von dort zum Substrat diffundiert, wo es in der chemischen Reaktion zum aller-größten Teil verbraucht wird. Lediglich die genannte Restmenge wird durch den dort vorhandenen Spalt 11 abgesaugt. Auf diese Weise wird verhindert, daß angeregtes Reaktionsgas von den Vakuumpumpen unmittelbar abgesaugt und damit der Umsetzung in chemische Verbindungen am Substrat entzogen wird. Auf diese Weise wird die Dichte angeregter Reaktionsgasteilchen vor der Substratoberfläche erhöht. Dies hat wiederum zur Folge, daß das für die Einstellung des geforderten Reaktionsgrades notwendige Stosszahlverhältnis geringer wird.

Wie in Figur 3 dargestellt, bestehen die Maßnahmen zur Ausbildung definierter Strömungsverhältnisse in der Wahl definierter Spaltbreiten und/oder Spaltlängen zwischen dem Substrat 6 und dem Innengehäuse 25 einerseits sowie in der Wahl einer effektiven Saugleistung der Vakuumpumpen am Saugstutzen 24.

Hierbei sind zwei Fälle zu unterscheiden: Außer dem Reaktionsgas wird auch das Arbeitsgas (Argon) in das Innengehäuse 25 eingelassen, oder das Reaktionsgas wird allein in das genannte Gehäuse eingelassen. In dem zuerst genannten Fall muß die Flußrate, die durch die Abmessungen des Spaltes 11 bestimmt wird, als Summe der Flußraten von Reaktionsgas und Arbeitsgas bei gewähltem Totaldruck im Innengehäuse 25 dem effektiven Saugvermögen der Vakuumpumpe durch den Totaldruck in der Vakuumkammer 23 angepaßt werden. Im zweiten Fall wird das Arbeitsgas durch die Verteileinrichtung 28 in die Vakuumkammer 23 eingelassen und gelangt durch Diffusion in das Innengehäuse 25, in dem der reaktive Prozeß abläuft. Der Spalt 11 ist in diesem Falle im wesentlichen nur für den Reaktionsgasfluß zu dimensionieren, der abgesaugt werden soll. Beiden Fällen ist jedoch gemeinsam, daß die Partialdruckdifferenz zwischen dem Innengehäuse 25 und dem Raum in der Vakuumkammer 23 klein gehalten wird, um nur einen geringen Reaktionsgasfluß durch den Spalt 11 zu erzeugen.

Beispiel:

In einer Vorrichtung nach Figur 3 wurde die effektive Saugleistung auf 100 l/s eingestellt. Die Magnetronkatode hatte eine Länge von 500 mm und wurde mit einer leistungsstabilisierten Stromversorgung mit einer Leistung von 1000 W versorgt. Der Gesamtdruck in der Vakuumkammer 23 betrug $4 \times 10^{-3}$ mbar, und der Abstand "a" zwischen Targetoberfläche und Substrat betrug 40 mm. In diesem Falle wurde über die Verteileinrichtung 5 ein Fluß von 350 sccm an reinem Sauerstoff in das Innengehäuse 25 eingelassen und über die Verteileinrichtung 28 ein Fluß von 250 sccm Argon. Die auf beiden Seiten des Spaltes 11 erzielte Druckdifferenz betrug $1,7 \times 10^{-3}$ mbar.

Die Halte- und Führungseinrichtung für die Substrate ist in den Figuren 1 bis 3 nicht näher dargestellt. In Frage kommt hierfür beispielhaft ein um eine Achse rotierender, ansonsten aber ortsfest gelagerter Substrathalter, oder ein plattenförmiger oder rahmenförmiger Substrathalter, der auf Rollen oder Schienen innerhalb der Vakuumkammer verfahrbar ist. Speziell für die Herstellung von Isolatorschichten ist es notwendig, daß der Substrathalter sich auf einem selbsteinstellenden Potential befindet ("floatendes" Potential). Bei solchen Schichten würde ein auf Massepotential befindlicher Substrathalter die Potentialverhältnisse in der Katodenumgebung stark beeinflussen, da leitfähige Flächen in diesem Raum die Wirksamkeit der Anode beeinflussen und damit Schichtungleichmäßigkeiten und Bogenentladungen erzeugen könnten. Aber auch für elektrisch leitfähige Schichten ist das floatendes Potential des Substrathalters jedenfalls kein Nachteil.

**Patentansprüche**

1. Verfahren zum Aufstäuben hochohmiger Schichten auf Substrate durch Katodenzerstäubung von elektrisch leitfähigen Targetmaterialien mittels einer mit Gleichspannung versorgten Magnetronkatode bei Unterdruck und in reaktiver Atmosphäre unter laufender Zufuhr von Reaktionsgas, wobei die Substrate planparallel zur Targetoberfläche gehalten oder geführt werden und sich zwischen den Ebenen von Targetoberfläche und Substrat eine Abschirmeinrichtung befindet, die auf einem Potential gehalten wird, das entweder positiv gegenüber dem Katodenpotential oder selbsteinstellend ist, dadurch gekennzeichnet, daß in Kombination
   a) das Reaktionsgas in kleinstmöglichem Abstand von der Targetoberfläche, jedoch außerhalb deren Umrißlinie, in der Draufsicht gesehen, zugeführt wird,
   b) der Abstand "a" zwischen Target- und Substratoberfläche kleiner als 60 mm, vorzugsweise zwischen 40 und 50 mm gehalten wird,
   c) der Abstand "d" zwischen der dem Target zugekehrten Oberfläche der Abschirmeinrichtung und dem Substrat kleiner als die Hälfte des Abstandes "a" gewählt wird.

2. Verfahren nach Anspruch 1, dadurch gekennzeichnet, daß man den Abstand "x" zwischen den Innenrändern der Abschirmeinrichtung zwischen dem 0,6-Fachen und dem 2,o-Fachen der Querabmessung "c" des Targets wählt.

3. Verfahren nach Anspruch 1, dadurch gekennzeichnet, daß der Abstand "d" maximal der Summe der Dicke der Abschirmeinrichtung und einem Spalt von 5 mm entspricht.

4. Verfahren nach Anspruch 1, dadurch gekennzeichnet, daß man die Abschirmeinrichtung auf ein solches Potential legt, daß mindestens 70 % des Entladungsstroms über die Abschirmeinrichtung geführt werden.

5. Verfahren nach Anspruch 1, dadurch gekennzeichnet, daß man eine zusätzliche in Zerstäubungsrichtung hinter der Abschirmeinrichtung liegende Anode auf ein solches Potential legt, daß mindestens 70 % des Entladungsstroms über die Anode geführt werden.

6. Verfahren nach Anspruch 5, dadurch gekennzeichnet, daß man die Abschirmeinrichtung an Massepotential legt.

7. Verfahren nach Anspruch 5, dadurch gekennzeichnet, daß man die Abschirmeinrichtung isoliert und selbsteinstellend anordnet.

8. Verfahren nach Anspruch 1, dadurch gekennzeichnet, daß man die Saugleistung einer den Unterdruck bestimmenden Vakuumpumpeinrichtung einerseits und die pro Zeiteinheit zugeführte Menge an Reaktionsgas andererseits so einstellt, daß aus der Reaktionszone zwischen Target und Substrat weniger als 1/3 vorzugsweise weniger als 1/5 des zugeführten Reaktionsgases unverbraucht abgezogen wird.

9. Verfahren nach Anspruch 8, dadurch gekennzeichnet, daß man das Verhältnis von zugeführter zu unverbraucht abgesaugter Menge an Reaktionsgas durch die Wahl einer Spaltweite zwischen einem die Katode umgebenden Innengehäuse und dem Substrat festlegt.

10. Vorrichtung zur Durchführung des Verfahrens nach Anspruch 1 mit einer Vakuumkammer, einer ein Target tragenden Magnetronkatode, einer Substrathalte- bzw. Führungseinrichtung, mit einer zwischen den Ebenen von Targetoberfläche und Substrat angeordneten Abschirmeinrichtung mit vorgebbarem oder selbsteinstellendem Potential, und mit einer Zuführ- und Verteileinrichtung für ein Reaktionsgas, gekennzeichnet durch die Kombination der Merkmale

a) die Verteileinrichtung (5) für das Reaktionsgas ist in kleinstmöglichem Abstand von der Targetoberfläche (4a) angeordnet, jedoch außerhalb deren Umrißlinie, in der Draufsicht gesehen,

b) der Abstand "a" zwischen Target- (4a) und Substratoberfläche (6) ist kleiner als 60 mm und liegt vorzugsweise zwischen 40 und 50 mm, und

c) der Abstand "d" zwischen der dem Target zugekehrten Oberfläche der Abschirmeinrichtung (7) und dem Substrat (6) ist kleiner als die Hälfte des Abstandes "a".

11. Vorrichtung nach Anspruch 10, dadurch gekennzeichnet, daß der Abstand "d" maximal der Summe der Dicke der Abschirmeinrichtung (7) und einem Spalt von 5 mm entspricht.

12. Vorrichtung nach Anspruch 10, dadurch gekennzeichnet, daß der Abstand "x" zwischen den Innenrändern (7a) der Abschirmeinrichtung (7) zwischen dem 0,6-Fachen und dem 2,0-Fachen der Querabmessung "c" des Targets (4) liegt.

13. Vorrichtung nach Anspruch 10, dadurch gekennzeichnet, daß die Reaktionszone (R) zwischen Target (4) und Substrat (6) einschließlich der Verteileinrichtung (5) für das Reaktionsgas von einem innerhalb der Vakuumkammer (23) angeordneten Innengehäuse (25) umgeben ist, das mit dem Innenraum der Vakuumkammer über mindestens einen, auf einer Seite vom Substrat (6) begrenzten Spalt (11) verbunden ist, der so dimensioniert ist, daß aus der Reaktionszone weniger als 1/3, vorzugsweise weniger als 1/5 des unverbrauchten Reaktionsgases abziehbar sind.

## Claims

1. A process for applying highly resistive layers to substrates by cathodic sputtering of electrically conductive target materials by means of a magnetron cathode, which is supplied with d.c. voltage, in a vacuum and in a reactive atmosphere with a continuous supply of reaction gas, wherein the substrates are held or guided so as to be plane-parallel to the target surface and wherein a screening device is arranged between the planes of the target surface and the substrate, which screening device is maintained at a potential which is either positive with respect to the cathode potential or is self-adjusting, characterised in that in combination

a) the reaction gas is supplied at the smallest possible distance from the target surface, but outside of its contour considered in a plan view,

b) the distance "a" between the target surface and the substrate surface is kept smaller than 60 mm, preferably between 40 and 50 mm,

c) the distance "d" between that surface of the screening device facing towards the target and the substrate is selected to be smaller than half the distance "a".

2. A process as claimed in Claim 1, characterised in that the distance "x" between the inner edges of the screening device is selected to amount to between 0.6 times and 2.0 times the cross-sectional dimension "c" of the target.

3. A process as claimed in Claim 1, characterised in that the distance "d" corresponds at the maximum to the sum of the thickness of the screening device and a gap of 5 mm.

4. A process as claimed in Claim 1, characterised in that the screening device is connected to a potential which is such that at least 70% of the discharging current is conducted across the screening device.

5. A process as claimed in Claim 1, characterised in that an additional anode, arranged following the screening device in the direction of sputtering, is connected to a potential which is such that at least 70% of the discharging current is conducted across the anode.

6. A process as claimed in Claim 5, characterised in that the screening device is connected to earth potential.

7. A process as claimed in Claim 5, characterised in that the screening device is arranged so as to be insulated and self-adjusting.

8. A process as claimed in Claim 1, characterised in that on the one hand the suction power of a vacuum pump device which defines the vacuum and on the other hand the quantity of reaction gas supplied per time unit are set to be such that less than 1/3, and preferably less than 1/5, of the supplied reaction gas is withdrawn, unreacted, from the reaction zone between the target and the substrate.

9. A process as claimed in Claim 8, characterised in that the ratio of the supplied quantity of reaction gas to the quantity of unreacted reaction gas withdrawn by suction is determined by the selection of a gap width between an inner housing, which surrounds the cathode, and the substrate.

10. A device for implementing the process claimed in Claim 1 comprising a vacuum chamber, a magnetron cathode which bears the target, a substrate holding- and guiding device, a screening device which is arranged between the planes of the target surface and the substrate and which possesses a predeterminable or self-adjusting potential, and comprising a supply- and distributing device for a reaction gas, characterised by the combination of the following features:
   a) the distributing device (5) for the reaction gas is arranged at the smallest possible distance from the target surface (4a) but outside of its outline considered in a plan view,
   b) the distance "a" between the target surface (4a) and the substrate surface (6) is smaller than 60 mm and preferably ranges between 40 and 50 mm, and
   c) the distance "d" between that surface of the screening device (7) facing towards the target and the substrate (6) is smaller than half the distance "a".

11. A device as claimed in Claim 10, characterised in that the distance "d" corresponds at the maximum to the sum of the thickness of the screening device (7) and a gap of 5 mm.

12. A device as claimed in Claim 10, characterised in that the distance "x" between the inner edges (7a) of the screening device (7) ranges between 0.6 times and 2.0 times the cross-sectional dimension "c" of the target (4).

13. A device as claimed in Claim 10, characterised in that the reaction zone (R) between the target (4) and the substrate (6), including the distributing device (5) for the reaction gas, is surrounded by an inner housing (25) which is arranged inside the vacuum chamber (23) and which is connected to the interior of the vacuum chamber via at least one gap (11) which on one side is delimited by the substrate (6) and which is dimensioned such that less than 1/3, and preferably less than 1/5, of the unreacted reaction gas can be withdrawn from the reaction zone.

## Revendications

1. Dispositif pour déposer sur des substrats des couches à forte résistance électrique par pulvérisation cathodique de matières-cibles électriquement conductrices, en recourant à une cathode de magnétron alimentée par une tension continue, sous dépression et en atmosphère réactive en présence d'une amenée de gaz de réaction, les substrats étant maintenus ou guidés plan-parallèlement à la surface de la cible, et un dispositif-écran se trouvant entre les plans de la surface de la cible et le substrat et étant maintenu à un potentiel qui est soit positif par rapport au potentiel de cathode, soit auto-établi, caractérisé par le fait qu'en combinaison :
   a) le gaz de réaction est amené à une distance aussi faible que possible de la surface de la cible, toutefois en dehors de la ligne de son contour vu en plan;
   b) la distance "a" entre surface de cible et surface de substrat est maintenue à une valeur inférieure à 60 millimètres, de préférence comprise entre 40 et 50 millimètres;
   c) la distance "d" entre la surface du dispositif-écran tournée vers la cible et le substrat est choisie inférieure à la moitié de la distance "a".

2. Procédé selon revendication 1, caractérisé par le fait que l'on adopte, pour la distance "x" comprise entre les bords intérieurs du dispositif-écran, une valeur comprise entre 0,6 fois et 2,0 fois la dimension transversale "c" de la cible.

3. Procédé selon revendication 1, caractérisé par le fait que la distance "d" correspond au maximum à la somme de l'épaisseur du dispositif-écran et d'un interstice de 5 millimètres.

4. Procédé selon revendication 1, caractérisé par le fait que l'on porte le dispositif-écran à un potentiel tel qu'au moins 70 % du courant de décharge passe par le dispositif-écran.

5. Procédé selon revendication 1, caractérisé par le fait qu'à une anode supplémentaire qui, sur la direction de pulvérisation, est située derrière le dispositif-écran, on applique un potentiel tel qu'au moins 70 % du courant de décharge passe par l'anode.

6. Procédé selon revendication 5, caractérisé par le fait que l'on met le dispositif-écran au potentiel de la masse.

7. Procédé selon revendication 5, caractérisé par le fait que l'on isole le dispositif-écran dont le potentiel s'établit de lui-même.

8. Procédé selon revendication 1, caractérisé par le fait que l'on règle, d'une part, la puissance d'aspiration d'un dispositif de pompe à vide déterminant la dépression et, d'autre part, la quantité de gaz de réaction amenée par unité de temps, de manière à extraire de la zone de réaction entre cible et substrat du gaz de réaction non utilisé, l'extraction étant inférieure à 1/3, de préférence 1/5, du gaz de réaction amené.

9. Procédé selon revendication 8, caractérisé par le fait que c'est par le choix d'une largeur d'interstice entre le substrat et une enceinte intérieure entourant la cathode que l'on fixe le rapport de la quantité de gaz de réaction amenée à la quantité non utilisée aspirée.

10. Dispositif de mise en oeuvre du procédé selon revendication 1, comportant une chambre à vide, une cathode de magnétron portant une cible, un dispositif de maintien et/ou de guidage de substrat, un dispositif-écran à potentiel imposé ou auto-établi agencé entre les plans de la surface de cible et du substrat, et un dispositif d'amenée et de répartition d'un gaz de réaction, caractérisé par la combinaison de caractéristiques :

   a) le dispositif de répartition de gaz de réaction (5) est agencé à une distance aussi petite que possible de la surface (4a) de la cible, toutefois en dehors de la ligne de son contour vu en plan;
   b) l'intervalle "a" entre cible (4a) et surface (6) du substrat est plus petit que 60 millimètres et est de préférence compris entre 40 et 50 millimètres; et
   c) l'intervalle "d" entre le substrat et la surface du dispositif-écran (7) tournée vers la cible est plus petit que la moitié de l'intervalle "a".

11. Dispositif selon revendication 10, caractérisé par le fait que l'intervalle "d" correspond au maximum à la somme de l'épaisseur du dispositif-écran (7) et d'un interstice de 5 millimètres.

12. Dispositif selon revendication 10, caractérisé par le fait que l'intervalle "x" entre les bords intérieurs (7a) du dispositif-écran (7) est compris entre 0,6 fois et 2,0 fois la dimension transversale "c" de la cible (4).

13. Dispositif selon revendication 10, caractérisé par le fait que la zone de réaction (R) entre cible (4) et substrat (6), y compris le dispositif répartiteur de gaz de réaction (5), est entourée par une enceinte intérieure (25) agencée à l'intérieur de la chambre à vide (23), laquelle enceinte communique avec le volume intérieur de la chambre à vide par au moins un interstice (11) qui borde un côté du substrat (6) et est dimensionné de manière à permettre d'extraire de la zone de réaction moins de 1/3, de préférence moins de 1/5, du gaz de réaction non utilisé.

# FIG.1

# FIG.2

FIG.3